# FASCICULE DE BREVET EUROPEEN

(11) **EP 2 924 455 B1**
(45) Date de publication et mention de la délivrance du brevet: **04.05.2022**
(21) Numéro de dépôt: 15160550.8
(22) Date de dépôt: 24.03.2015
(51) Int. Cl.: G01R 31/40, H01M 10/48, H02H 1/06, H02J 7/00, G01R 31/3835, G01R 19/165, H01M 10/42

(54) **Dispositif de surveillance muni d'un gestionnaire de décharge de batterie et procédé de gestion de décharge**
Überwachungsvorrichtung, die mit einem Steuerungssystem der Batterieentladung ausgestattet ist, und Steuerungsverfahren der Entladung.
A monitoring device comprising a management of battery discharge and method of battery discharge management

(30) Priorité: 24.03.2014 FR 1400711
(43) Date de publication de la demande: 30.09.2015
(73) Titulaire: Schneider Electric Industries SAS, 92500 Rueil-Malmaison (FR)
(72) Inventeur: Sorin, Joel, 38420 Domène (FR); Masseboeuf, Bertrand, 38140 Beaucroissant (FR)
(74) Mandataire: Talbot, Alexandre

(56) Documents cités:
- EP-A1- 0 948 828
- EP-A2- 2 557 651
- EP-B1- 0 948 828
- DE-A1- 2 936 675
- DE-A1-102012 211 092
- GB-A- 2 292 249
- JP-A- 2003 067 091
- US-A- 4 839 248
- US-A1- 2013 308 239

## Description

### Domaine technique de l'invention

L'invention est relative à un dispositif de surveillance d'une alimentation électrique et comportant des alimentations principale et secondaire.

L'invention est également relative à un procédé de gestion de la décharge d'une batterie sécurisant l'alimentation d'un dispositif de surveillance.

### État de la technique

L'alimentation primaire d'un circuit de commande peut être interrompue dans certains cas accidentels. Il est intéressant de connaître l'état du circuit de commande ou de données présentes dans le circuit de commande lors de son arrêt pour défaut d'alimentation. Afin de stocker certaines données intéressantes, le circuit de commande possède un circuit de mémorisation des informations.

Pour assurer le fonctionnement du circuit de mémorisation avant et après la disparition de l'alimentation primaire, une source électrique secondaire est connectée au circuit de mémorisation ce qui permet de fournir la puissance électrique nécessaire au bon fonctionnement du circuit de mémorisation.

De manière traditionnelle, cette source électrique secondaire est une batterie électrique, qui doit être en permanence prête à alimenter le circuit de commande.

Le document US5224011 divulgue un système où une batterie est utilisée pour assurer la sauvegarde des informations dans un circuit électrique en cas de perte de l'alimentation principale.

Le document US5089928, utilise une batterie de secours pour assurer le fonctionnement d'un écran LCD après la coupure de l'alimentation principale du système. La batterie est activée manuellement.

Cependant, la durée de vie de la batterie est limitée ce qui nécessite une surveillance de l'état de la batterie afin de signaler sa fin de vie.

Ils existent certains documents qui adressent cette problématique. A titre d'exemple, le document EP0279692 décrit un système utilisant une batterie électrique pour assurer le fonctionnement d'un circuit de commande. L'état de la batterie est vérifié manuellement par l'activation d'un circuit test comportant une LED qui indique la tension mesurée aux bornes de la batterie.

Lors de la période d'attente, une des bornes et/ou une des électrodes internes de la batterie peut s'oxyder. Il est alors intéressant de réaliser une action de désoxydation pour retrouver une batterie opérationnelle.

Dans le cas où les bornes de la batterie sont passivées, le document US6118251, décrit un procédé de dépassivation d'une batterie électrique par des séquences d'impulsions électriques.

Le document EP0444023, décrit un système pour la dépassivation d'une batterie électrique en contrôlant la puissance débitée par la batterie jusqu'à la dissipation des cristaux de sel sur une électrode et le retour de la puissance ou l'écoulement d'une durée maximale.

Le document EP0891000 décrit un procédé pour vérifier l'état d'une batterie électrique avant son utilisation et permet la dépassivation de la batterie ainsi qu'un calcul de la durée de vie résiduelle de la batterie. Le document EP2557651 décrit un dispositif de suivi de la tension aux bornes d'une batterie ("backup battery") qui se décharge dans une charge électrique. Le dispositif de surveillance est configuré pour surveiller l'alimentation primaire du disjoncteur et non l'alimentation fournie par la batterie.

### Objet de l'invention

L'invention a comme objet de fournir un disjoncteur comportant un dispositif de surveillance disposant d'une alimentation secondaire selon la revendication 1 et- qui propose une meilleure qualité de service, notamment lors de la détection d'une anomalie.

L'invention a également comme objet de réaliser un procédé de gestion de la décharge d'une batterie dans un disjoncteur muni d'un dispositif de surveillance selon la revendication 2 qui soit facile à mettre en œuvre tout en assurant une réalisation fiable et répétable pour une intégration industrielle.

D'autres avantages et caractéristiques ressortiront plus clairement de la description qui va suivre de modes particuliers de réalisation de l'invention donnés à titre d'exemples non limitatifs et représentés aux dessins annexés, dans lesquels :
- les figures 1a et 1b représentent, de manière schématique, deux modes de réalisation d'un dispositif de surveillance,
- la figure 2 représente un organigramme des étapes pour la gestion de l'état de la batterie,
- la figure 3 représente les instants et les cycles cadençant l'évolution du courant émis par la batterie dans le cadre d'un procédé de gestion de la décharge de la batterie,
- la figure 4 représente des exemples de l'évolution temporelle de la tension électrique mesurée sur les bornes de la batterie.

### Description détaillée

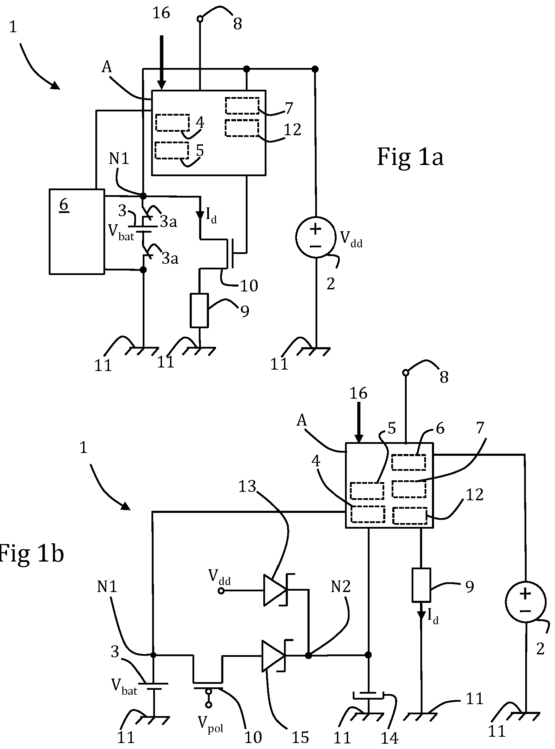

La figure 1a illustre un dispositif de surveillance 1, par exemple un disjoncteur, configuré pour surveiller une ou plusieurs lignes d'alimentation électrique. Le dispositif de surveillance 1 est destiné à être relié aux lignes d'alimentation électrique et configuré pour mesurer les caractéristiques électriques des lignes, par exemple la tension présente sur la ligne et/ou le courant qui circule dans la ligne électrique. Dans le cas d'un disjoncteur, la coupure de la ligne d'alimentation surveillée peut apparaître en cas de détection d'une anomalie.

Le dispositif de surveillance 1 comporte une série de bornes d'alimentation destinées à être connectées à une source d'alimentation primaire 2. La source d'alimentation primaire est la source d'alimentation principale, c'est-à-dire qu'elle alimente majoritairement ou en priorité les différents composants du dispositif de surveillance 1.

Afin de pallier une déficience de la source d'alimentation primaire 2, le dispositif de surveillance 1 comporte une source d'alimentation secondaire 3 qui est formée par une batterie. La batterie 3 comporte deux contacts 3a qui relient la batterie 3 aux éléments du dispositif de surveillance 1. La batterie 3 est configurée pour alimenter au moins une partie du dispositif de surveillance et de préférence seulement une partie du dispositif de surveillance. Le dispositif de surveillance surveille une ligne d'alimentation qui peut être la ligne d'alimentation principale ou une autre ligne d'alimentation différente de la batterie 3.

De manière avantageuse, tous les circuits électroniques ou une partie seulement des circuits électroniques du dispositif de surveillance 1 sont alimentés par la batterie 3 afin de conserver une autonomie importante en cas de disparition de l'alimentation principale 2.

Dans un mode de réalisation particulier, le dispositif de surveillance 1 comporte un circuit de mémorisation 4 qui enregistre des indicateurs liés aux grandeurs électriques mesurées. De manière avantageuse, la batterie 3 alimente au moins le circuit de mémorisation 4. Dans le cas d'un disjoncteur, le circuit de mémorisation 4 enregistre préférentiellement des indicateurs liés aux causes de déclenchement du disjoncteur.

On entend par batterie 3 un dispositif électrochimique qui convertit l'énergie chimique en énergie électrique grâce à une réaction chimique d'oxydoréduction. La batterie peut être non rechargeable et porter le nom de pile ou pile électrique. Dans d'autres modes de réalisation, la batterie peut être rechargeable.

La source d'alimentation secondaire 3 est placée dans le dispositif de surveillance 1 de manière à éviter la mise en place d'une nouvelle série de lignes d'alimentation dissociées de la première série de lignes d'alimentation.

De cette manière, il est possible d'avoir un dispositif de surveillance 1 qui est compact et qui assure un fonctionnement quasi-permanent.

Comme le dispositif de surveillance 1 peut être placé dans des environnements agressifs, il est avantageux d'avoir une source d'alimentation secondaire 3 qui est également capable de supporter de telles conditions.

Dans un mode de réalisation avantageux, le dispositif de surveillance 1 est configuré de sorte que la source d'alimentation primaire 2 soit la ligne d'alimentation à surveiller ou soit reliée à la ligne d'alimentation à surveiller. La ligne d'alimentation à surveiller est destinée à alimenter une ou plusieurs autres charges électriques. Si le dispositif de surveillance 1 constate une anomalie sur la ligne d'alimentation, il va provoquer la déconnexion de la ligne ce qui va se traduire par la disparition de la source d'alimentation primaire 2.

Ainsi, dans cette configuration, lorsque la ligne d'alimentation à surveiller est arrêtée, l'alimentation principale 2 fait défaut et il faut basculer sur l'alimentation secondaire 3.

Dans le mode de réalisation représenté à la figure 1a, le dispositif de surveillance 1 comporte avantageusement un circuit de commande A qui est configuré pour analyser la ligne d'alimentation à surveiller, par exemple au moyen d'un microcontrôleur. Le circuit de mémorisation 4 est couplé au circuit de commande. Dans le mode de réalisation illustré à la figure 1, le circuit de mémorisation 4 fait partie du circuit de commande A.

Préférentiellement, le circuit de commande A ou une partie du circuit de commande (notamment le circuit de mémorisation 4) est alimenté par la batterie 3 en cas de défaut de l'alimentation principale 2.

Le dispositif de surveillance 1 comporte encore un circuit de gestion 5 configuré pour analyser l'état de la batterie 3 et particulièrement pour détecter une éventuelle défaillance de la batterie 3. Le circuit de gestion est configuré pour détecter la défaillance de la batterie lorsque le dispositif de surveillance est alimenté par son alimentation primaire.

L'utilisation d'un circuit de gestion 5 qui vérifie l'état de la batterie 3 permet de savoir, au cours du temps, si la source d'alimentation secondaire 3 est en mesure d'alimenter le circuit de commande et donc d'assurer un bon fonctionnement du dispositif de surveillance 1. La tension aux bornes de la batterie est mesurée lorsque le dispositif de surveillance est alimenté par l'alimentation primaire.

Des moyens de mesure 6 sont configurés pour mesurer la tension V_{bat} aux bornes de la batterie 3. Les moyens de mesure 6 sont reliés à une entrée d'un comparateur 7 pour lui fournir une information relative à l'état de la batterie 3, au moyen de la tension V_{bat}. Le comparateur 7 est connecté au circuit de gestion 5 de manière à pouvoir lui transmettre un ou plusieurs signaux. Dans l'exemple illustré, le circuit de gestion 5, le comparateur 7 et le dispositif de mémorisation sont formé dans le circuit de commande A qui est par exemple un microcontrôleur.

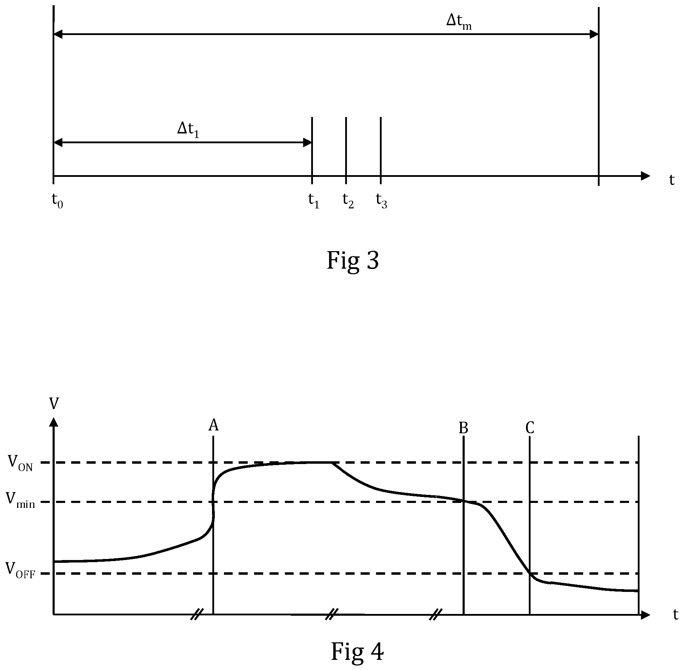

Les moyens de mesure 6 peuvent être configurés pour réaliser la mesure de la tension aux bornes de la batterie 3 de manière périodique, période symbolisée par Δtₘ, sur la figure 3, par exemple au moyen d'une horloge. Il est également possible de réaliser la mesure de la batterie 3 à réception d'un signal de mesure. Le terme tension mesurée V_{bat} peut représenter la tension aux bornes de la batterie 3 ou une grandeur représentative de cette tension. Dans un mode de réalisation particulier, la tension aux bornes de la batterie V_{bat} est mesurée toutes les 24h, c'est-à-dire Δtₘ = 24h.

Le comparateur 7 est configuré pour comparer la tension mesurée V_{bat} à un premier seuil V_{OFF} et à un deuxième seuil Vₘᵢₙ. Le deuxième seuil Vₘᵢₙ est supérieur au premier seuil V_{OFF}.

La valeur du deuxième seuil Vₘᵢₙ correspond à une batterie 3 fonctionnelle. Ainsi, si la tension mesurée V_{bat} est supérieure à la deuxième valeur seuil Vₘᵢₙ, le comparateur 7 émet une première information représentative de cette comparaison au circuit de gestion 5 et la batterie 3 est considérée comme fonctionnelle.

L'intervalle compris entre la première valeur seuil V_{OFF} et la deuxième valeur seuil Vₘᵢₙ correspond à une batterie 3 présentant éventuellement un problème pouvant être corrigé. Ainsi, si la tension mesurée V_{bat} est comprise dans cet intervalle, le comparateur 7 renvoie une deuxième information associée vers le circuit de gestion 5.

La valeur du premier seuil V_{OFF} correspond à une batterie 3 défectueuse non récupérable. Ainsi, si la tension mesurée V_{bat} est inférieure à la première valeur seuil V_{OFF}, le comparateur 7 émet une troisième information représentative de cette comparaison et la batterie 3 est considérée comme défectueuse par le circuit de gestion 5. La batterie 3 doit, par exemple, être remplacée.

Si le circuit de gestion 5 reçoit la première information, il peut stocker cette information dans une mémoire. La première information peut être une absence de signal.

Si le circuit de gestion 5 reçoit la troisième information, il peut avertir l'utilisateur que la batterie 3 est défectueuse et que son remplacement est à prévoir afin de maintenir le fonctionnement du dispositif de surveillance 1 dans toutes ses performances. La signalisation d'une batterie 3 défaillante peut être réalisée au moyen d'un indicateur lumineux, par exemple au moyen d'une diode électroluminescente. Il est également possible d'utiliser une onde électromagnétique ou un signal électronique pour informer l'utilisateur de la défaillance de la batterie 3. A titre d'exemple, le circuit de gestion 5 indique la fin de vie de la batterie 3 au moyen d'une sortie 8.

Si le circuit de gestion 5 reçoit la deuxième information, il engage un protocole de test afin de déterminer si la batterie 3 est fonctionnelle ou défectueuse.

Le circuit de gestion 5 est couplé à une charge électrique 9 configurée pour décharger la batterie 3. Dans ces conditions, un courant électrique circule depuis la batterie 3 vers la charge électrique 9 (à travers les bornes 3a de la batterie 3).

Ainsi, une décharge partielle de la batterie 3 est déclenchée lorsque la tension mesurée V_{bat} aux bornes 3a de la batterie 3 est supérieure au premier seuil V_{OFF} et inférieure au deuxième seuil Vₘᵢₙ.

La décharge de la batterie 3 est déclenchée par le circuit de gestion 5 qui définit les conditions de la décharge, par exemple l'intensité du courant, la durée du courant, la quantité de charges électriques transférée par la batterie 3, la forme du courant dans le temps (intensité en fonction du temps) et/ou le nombre de répétitions d'un courant de décharge définissant un motif.

Un courant de décharge I_{d} est émis depuis la batterie 3, et le courant de décharge I_{d} est configuré pour éliminer au moins partiellement une couche de passivation présente sur une borne ou une des électrodes internes de la batterie 3.

A titre d'exemple, le courant de décharge I_{d} se présente sous la forme de plusieurs impulsions de forme carrée.

Dans un mode de réalisation, le circuit de gestion 5 est relié à l'électrode de commande d'un interrupteur 10. L'interrupteur 10 relie électriquement les deux bornes 3a de la batterie 3 ou il relie une des bornes 3a de la batterie 3 à un potentiel de référence 11 qui est en mesure d'écouler les charges électriques. Ce mode de réalisation est avantageux car il est compact et il permet de commander facilement le passage du courant depuis la batterie 3.

Dans un mode de réalisation encore plus particulier, l'interrupteur 10 est un transistor. Le transistor 10 permet à un courant de décharge I_{d} de transiter depuis l'anode de la batterie 3 vers le potentiel de référence 11 à travers la charge électrique 9. Le potentiel de référence 11 est par exemple la masse. L'utilisation d'un transistor 10 associé à la charge électrique 9 permet de réaliser un dispositif extrêmement compact tout en autorisant un bonne maitrise de la quantité de courant à faire transiter. Le transistor 10 permet de fixer la durée de passage du courant et la charge électrique 9 permet de fixer l'intensité du courant.

Le dispositif de surveillance 1 comporte avantageusement un compteur 12 qui est configuré pour une grandeur représentative du passage des électrons, c'est-à-dire une grandeur représentative des porteurs de charge électrique lors des multiples activations du courant de décharge. Cette grandeur permet de connaître le nombre de charges qui a été utilisé pour essayer de dépassiver les bornes de la batterie.

A titre d'exemple, le dispositif de surveillance 1 comporte avantageusement un compteur 12 qui est configuré pour mesurer la quantité de courant traversant les bornes 3a de la batterie 3 ou pour compter le nombre de passage d'un courant traversant les bornes 3a de la batterie 3. Le compteur 12 peut être un compteur qui reçoit une information du circuit de gestion 5 indiquant le déclenchement d'un courant de décharge I_{d}. Le compteur 12 enregistre alors le nombre d'itérations d'application du courant de décharge I_{d}. Le compteur 12 peut également être un compteur mesurant l'activation de l'électrode commande de l'interrupteur 10. Le compteur 12 peut encore être un dispositif de mesure du courant I_{d} circulant à travers la batterie 3. L'information enregistrée est alors une quantité d'électrons ayant transités par les bornes 3a de la batterie 3.

Dans un mode de réalisation particulier, le circuit de gestion 5 est connecté au compteur 12. Le circuit de gestion 5 est configuré pour signaler la défaillance de la batterie 3 si la deuxième information est envoyée par le comparateur 7 et si le compteur 12 présente une valeur supérieure à une valeur critique N_{C}. Dans ces conditions, il a été détecté que la tension V_{bat} aux bornes de la batterie 3 est dans l'intervalle où le protocole de test doit être appliqué et le compteur 12 indique que le protocole de test a déjà été appliqué plusieurs fois. Il semble donc que la chute de tension ne soit pas liée à une couche de passivation ou que le passage d'un courant aux bornes de la batterie 3 ne soit pas suffisant pour casser la couche de passivation. L'émission d'un signal de défaillance permet d'anticiper une aggravation de la situation où la batterie 3 ne sera plus en mesure de fournir une tension suffisante pour alimenter le circuit de commande ou au moins le circuit de mémorisation 4.

Cette configuration permet de détecter plus rapidement une batterie 3 qui ne sera pas fonctionnelle et cela permet de réactiver certaines batteries 3 passivées sans intervention d'un utilisateur.

Dans un mode de réalisation particulier, le circuit de mesure 6 est configuré pour mesurer la tension V_{bat} aux bornes de la batterie 3 dès qu'une batterie 3 vient d'être installée.

Dans ces conditions, une batterie 3 nouvellement placée est automatiquement détectée ce qui permet à l'utilisateur de connaître immédiatement si la nouvelle batterie 3 présente intrinsèquement un problème. On évite ainsi à l'utilisateur qui vient de placer une nouvelle batterie de revenir changer cette batterie qui est défectueuse.

Il est avantageux de prévoir que le dispositif de surveillance est dépourvu de moyen de recharger la batterie 3 par l'intermédiaire de l'alimentation principale afin de gagner en compacité.

Le circuit de mesure 6, le comparateur 7 et le circuit de gestion 5 peuvent être réalisés par des circuits électroniques distincts ou ils peuvent être au moins partiellement réalisés dans un même circuit électronique par exemple le circuit de commande A et notamment par un microcontrôleur.

L'utilisation d'un microcontrôleur pour former au moins une partie du circuit de gestion 5, du circuit de mesure 6, du comparateur 7 et/ou du compteur 12 est avantageuse car cela permet de réaliser un dispositif compact et peu consommateur en énergie.

Dans une configuration particulière représentée à la figure 1b, la source d'alimentation électrique primaire 2 applique une tension d'alimentation V_{dd} au dispositif de surveillance 1 par l'intermédiaire d'une première diode 13. Cette configuration est particulièrement avantageuse lorsque l'alimentation primaire provient de la ligne d'alimentation à surveiller qui est une alimentation en courant alternatif ou continu. Cette configuration peut également être appliquée au dispositif selon la figure 1a.

La tension V_{dd} est appliquée à l'anode de la première diode 13. La première diode 13 est agencée pour alimenter le circuit de gestion 5. La cathode de la première diode 13 est ici connectée à l'entrée du circuit de commande A.

Dans un mode de réalisation avantageux, la première diode 13 est connectée également à une première borne d'une capacité de découplage 14 configurée pour lisser la tension appliquée par les alimentations. Une deuxième borne de la capacité de découplage 14 est connectée au potentiel de référence 11, ici à la terre. L'alimentation du circuit de gestion 5 par la source primaire 2 permet d'économiser la batterie électrique 3 qui n'intervient qu'en cas de défaut de la source primaire 2.

Il en est avantageusement de même pour les autres éléments servant à suivre l'état de la batterie 3 à savoir le circuit de mesure 6, le compteur 12 et le comparateur 7.

L'anode de la batterie 3 est connectée à la source du transistor 10. Le circuit de gestion 5 applique une tension Vₚₒₗ sur la grille dudit transistor 10, ce qui permet de commander le passage d'un courant depuis la batterie 3 (figure 1b).

Dans l'exemple illustré, le drain du transistor 10 est connecté à l'anode d'une deuxième diode 15. La cathode de la diode 15 est connectée à l'entrée du circuit de commande 4. La connexion électrique entre les deux diodes 13 et 15 avec le condensateur de découplage 14 définit un deuxième nœud N₂. A titre d'exemple, le transistor 10 est un transistor MOSFET de type P.

Dans un mode de réalisation avantageux, la tension d'alimentation V_{dd}, fournie par l'alimentation primaire 2 est d'environ 3,3V avec une tolérance de plus ou moins 5%. La tension électrique V_{bat} de la batterie 3 est d'environ 3,6V pour une batterie 3 pleinement chargée.

Dans un mode de réalisation, le condensateur de découplage 14 est un condensateur ayant une capacité de l'ordre de C_{d}=1µF.

Dans une configuration particulière, la première diode 13 et la deuxième diode 15 sont des diodes Schottky ou silicium ayant une faible tension directe.

Dans un mode de fonctionnement particulier illustré à la figure 1b, le courant de décharge passe au travers du circuit de commande A. La charge électrique 9 est connectée entre le circuit de commande A et le potentiel de référence 11. A titre d'exemple, une résistance électrique de l'ordre de 1kΩ peut être utilisée pour former la charge électrique 9. Dans ce cas, un courant de décharge I_{d} d'environ 3mA est avantageux pour s'assurer de la dégradation de la couche de passivation. Le courant de décharge est avantageusement égal à 3mA, ce qui correspond avec les variations de réalisation à un courant compris entre 2,7 entre 3,3mA.

Dans cette configuration, un premier nœud électrique N₁ est défini par la connexion de l'anode de la batterie 3 avec la borne de la source du transistor 10 et l'entrée d'alimentation du circuit de commande A. La tension V_{bat} de la batterie 3 peut être mesurée au nœud N₁ par les moyens de mesure 6. Un deuxième nœud électrique N₂ est défini par la connexion de la cathode de la première diode 13 avec la cathode de la deuxième diode 14 et la deuxième entrée du circuit de commande. Une borne du condensateur de découplage 14 est également reliée au nœud N₂.

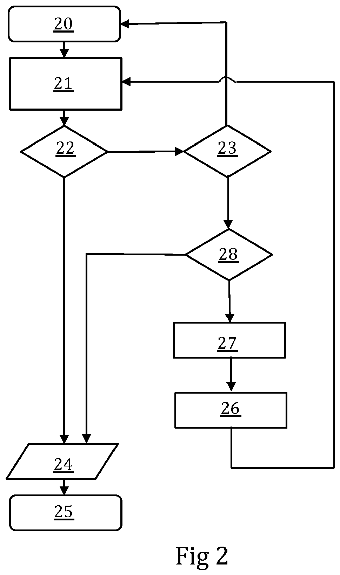

En fonctionnement, le dispositif de surveillance 1 peut appliquer le protocole de suivi de l'état de la batterie 3 qui va suivre et illustré à la figure 2.

Le début du processus est représenté par l'étape 20, la batterie 3 est présente et le dispositif de surveillance 1 est alimenté soit par la batterie 3 soit par la source d'alimentation primaire 2. L'étape 20 peut être considérée comme un état de veille.

Un ordre de mesure est émis pour initier la mesure de la tension V_{bat} aux bornes 3a de la batterie 3. Avantageusement, la mesure de la tension V_{bat} est réalisée en faisant passer un courant à travers de la charge.

A une étape 21, la tension V_{bat} aux bornes de la batterie 3 est mesurée par les moyens de mesure 6. Préférentiellement, la mesure de la tension V_{bat} peut être réalisée par de multiples mesures successives, ce qui permet de calculer par exemple une moyenne de la tension V_{bat}, afin d'obtenir une valeur plus fiable de V_{bat}.

A une étape 22-23, la tension V_{bat} mesurée est comparée aux première et deuxième valeurs seuils Vₘᵢₙ et V_{OFF}.

A l'étape 22, la tension V_{bat} mesurée est comparée à la première valeur seuil V_{OFF} (V_{bat}<V_{OFF} ?).

Si la tension V_{bat} est inférieure à la première valeur seuil V_{OFF} (V_{bat}<V_{OFF}), la batterie 3 est considérée comme défaillante (étape 24) et il est avantageux de la remplacer.

Avantageusement, la détection de l'état défaillant est associée à la signalisation de cet état auprès de l'utilisateur (étape 25).

Suite à cet événement de signalisation, le procédé de gestion peut se terminer par une phase d'attente pour le remplacement de la batterie 3. La signalisation peut être réalisée, par exemple, avec un signal avantageusement discret envoyé par la sortie 8 à une diode électroluminescente ou encore un signal numérique ou analogique envoyé à un autre organe du dispositif de surveillance. Dans un mode de réalisation particulier, la valeur de seuil V_{OFF} est égale par exemple à 2.3V.

Si la tension V_{bat}, à l'étape 22, est supérieure à la première valeur de seuil V_{OFF} (V_{bat}>V_{OFF}), la tension V_{bat} mesurée est comparée à la deuxième valeur seuil Vₘᵢₙ. A l'étape 23, la tension V_{bat} mesurée est comparée à la deuxième valeur de seuil Vₘᵢₙ (V_{bat}>Vₘᵢₙ ?).

Si la tension V_{bat} est supérieure à la deuxième valeur de seuil Vₘᵢₙ (V_{bat}>Vₘᵢₙ), la batterie 3 est considérée comme fonctionnelle. Cette information peut être stockée en mémoire.

Le procédé de gestion revient alors vers un état d'attente (étape 20) ou il recommence une étape de mesure de la tension V_{bat} (étape 21). De manière avantageuse, le procédé de suivi retourne à l'état initial 20 et il attend un nouvel ordre de mesure afin d'éviter de trop solliciter la batterie 3.

Si la tension V_{bat} est inférieure à la deuxième valeur de seuil Vₘᵢₙ (V_{bat}<Vₘᵢₙ) cela veut dire que la tension V_{bat} est dans l'intervalle de tension compris entre la première valeur seuil V_{OFF} et la deuxième valeur seuil Vₘᵢₙ. La batterie 3 présente éventuellement un problème pouvant être corrigé.

Un protocole supplémentaire de test de la batterie 3 est engagé (étape 26). Un courant de décharge I_{d} est appliqué sur la batterie 3 à travers la charge 9 afin de casser la couche de passivation. De manière avantageuse, avec l'application d'un courant de décharge I_{d}, le compteur 12 est incrémenté afin de connaître le nombre d'occurrences de ce type de problème (étape 27).

Le compteur est configuré pour enregistrer le nombre d'itérations de l'activation du courant de décharge I_{d}. Comme indiqué précédemment, le compteur enregistre une donnée représentative du nombre d'itérations (n). Il est donc possible d'enregistrer un temps, une charge électrique, le nombre d'itérations effectuées ou une autre grandeur.

L'incrémentation du compteur (étape 27) peut être réalisée, avant l'étape 26, pendant l'étape 26 ou après l'étape 26.

Après application du courant de décharge I_{d} pendant une durée prédéfinie, la tension V_{bat} aux bornes de la batterie 3 est mesurée encore une fois (étape 21) afin de mesurer l'évolution de la tension V_{bat}.

Comme précédemment, la tension mesurée V_{bat} est comparée aux première et deuxième valeurs de tension (étapes 22 et 23).

Si la tension V_{bat} est supérieure à la deuxième valeur de seuil Vₘᵢₙ (V_{bat}>Vₘᵢₙ), la batterie 3 est considérée comme fonctionnelle. Cette information peut être stockée en mémoire et il est avantageux de réinitialiser le compteur 12.

Si la tension V_{bat} est inférieure à la première valeur de seuil (V_{bat}<V_{OFF}), la batterie 3 est considérée comme défaillante et il est avantageux de la remplacer. Le protocole décrit précédemment peut être appliqué.

Si la tension V_{bat} est dans l'intervalle de tension compris entre la première valeur seuil V_{OFF} et la deuxième valeur seuil Vₘᵢₙ, il est possible de générer une nouvelle fois un courant de décharge I_{d}.

Afin d'éviter la répétition du courant de décharge I_{d} aux bornes de la batterie 3 jusqu'à ce que la tension V_{bat} soit inférieure à la première valeur de seuil V_{OFF}, il est avantageux d'introduire une étape 28 de comparaison de la valeur enregistrée dans le compteur 12 par rapport à une valeur critique N_{C} (n<N_{C} ?). Là encore la position de l'étape 28 par rapport aux étapes 26 et 27 est peu importante.

Une fois la valeur limite N_{C} atteinte, on considère que la batterie 3 ne peut plus être réparée et la batterie est considérée comme défaillante (étape 24). Le protocole de défaillance est avantageusement appliqué afin de prévenir l'utilisateur.

Ainsi, si la tension mesurée V_{bat} est comprise entre les première et deuxième valeurs seuil, il est avantageux de réaliser une comparaison de la valeur du compteur par rapport à une valeur critique (étape 28) afin de déterminer si la batterie 3 est défectueuse ou si un courant de décharge peut améliorer la situation. Ceci constitue un critère supplémentaire permettant de détecter une batterie défaillante.

Les étapes 22 et 23 peuvent être interverties dans la mesure où il est possible de déterminer si la tension V_{bat} est inférieure à la première valeur de seuil V_{OFF}, supérieure à la deuxième valeur de seuil Vₘᵢₙ ou dans l'intervalle indiqué précédemment.

Dans un mode de réalisation avantageux, le protocole de gestion comporte une répétition de certaines étapes de manière périodique afin de suivre l'évolution de l'état de la batterie 3 dans le temps. Avantageusement, la mesure de la tension V_{bat} aux bornes 3a de la batterie 3 est réalisée de manière périodique.

Dans un mode de réalisation avantageux, le protocole de gestion est déclenché lorsqu'une nouvelle batterie 3 est connectée au dispositif de surveillance 1. De cette manière, l'utilisateur sait rapidement si la nouvelle batterie 3 est fonctionnelle ou défaillante.

Il est également possible de forcer le protocole de mesure, par exemple au moyen d'une action de l'utilisateur soit par l'appui sur un bouton poussoir 16 soit par la sollicitation d'une interface de communication.

Si la batterie 3 est considérée comme fonctionnelle, c'est-à-dire si la tension mesurée est supérieure au seuil Vₘᵢₙ, il est avantageux de réaliser la mesure de tension selon une première période Δtₘ₁, par exemple égale à 24h. En revanche, la batterie 3 peut être considérée comme potentiellement défaillante, c'est-à-dire si la tension mesurée est inférieure au seuil Vₘᵢₙ mais supérieure au seuil V_{OFF}

De manière avantageuse, lorsque la tension aux bornes de la batterie 3 est mesurée à l'intérieur de l'intervalle défini par les tensions Vₘᵢₙ et V_{OFF}, un courant de décharge I_{d} est appliqué et la tension V_{bat} est mesurée après une période prédéfinie d'attente qui fait suite à l'arrêt du courant de décharge I_{d}. Dans ce cas de figure, il est possible de travailler avec une nouvelle période qui est réduite par rapport au cas où la batterie est considérée fonctionnelle.

A titre d'exemple, de bons résultats ont été obtenus avec une période Δtₘ réduite à 19 secondes entre la fin de l'application du courant I_{d} et la mesure de la tension V_{bat}.

Dans un mode de fonctionnement particulier, la mesure de la tension V_{bat}, réalisée pendant l'étape 21, peut être décrite schématiquement de la manière représentée à la figure 3. Dans le mode de réalisation illustré à la figure 3, la mesure de la tension est réalisée de manière cyclique. La période est égale au temps Δtₘ.

Comme indiqué précédemment, pour obtenir une mesure plus juste de la tension V_{bat} aux bornes de la batterie, plusieurs mesures de tensions sont préférentiellement réalisées. Par exemple, trois mesures de tension sont effectuées.

Ces mesures sont réalisées à des instants t₁, t₂ et t₃ sur la figure 3. Les trois mesures peuvent être espacées d'une même période de repos ou il est possible d'appliquer une période de repos différente entre la première et la deuxième mesures et entre la deuxième et la troisième mesures.

Dans un mode de fonctionnement donnant de bons résultats, un temps d'attente au moins égal à 2ms est présent entre deux mesures de tension successives.

Dans un mode de fonctionnement particulier, durant une période Δtₘ, une phase de décharge avec un courant égal à I_{d} est appliquée. Cette phase de décharge périodique permet de solliciter les bornes de la batterie pour réduire la formation d'une couche de passivation.

De manière préférentielle, les mesures de tensions sont effectuées après un premier temps d'attente Δt₁, par exemple au moins égal à 48ms. Ce premier temps d'attente correspond à la durée qui sépare la fin de l'application du courant I_{d} et la première mesure de tension V_{bat}. Le premier temps d'attente permet de fiabiliser la mesure de tension.

Durant le premier temps d'attente, il est possible d'appliquer un deuxième courant qui est inférieur au premier courant I_{d}. Le deuxième courant est avantageusement inférieur à la moitié du premier courant I_{d}. Il est également possible d'avoir un courant nul durant le premier temps d'attente.

Durant cette période, il y a une phase de décharge avec un courant égal à I_{d} de t₀ à t₃ et une phase de repos à courant très inférieur à I_{d} de t₃ à la fin de la période Δtₘ.

A titre d'exemple, de bons résultats expérimentaux ont été obtenus avec une période Δtₘ égale à 19 secondes et une phase t₀ à t₃, où le courant est égal à Id, égale à 50 millisecondes.

A titre d'exemple, l'évolution de la tension aux bornes de la batterie est représentée à la figure 4. Jusqu'au moment A, la tension V_{bat} mesurée est comprise entre les tensions V_{OFF} et Vₘᵢₙ. Il existe un doute sur l'état de la batterie qui peut être fonctionnelle mais passivée. Jusqu'au moment A, un courant de décharge est appliqué à partir de la batterie 3.

A partir du moment A et jusqu'au moment B, la tension V_{bat} est supérieure à la tension Vₘᵢₙ et la batterie 3 est considérée comme fonctionnelle. La mesure de la tension V_{bat} est réalisée périodiquement.

A partir du moment B et jusqu'au moment C, la tension V_{bat} est comprise entre la tension Vₘᵢₙ et la tension V_{OFF}. Un courant de décharge est de nouveau appliqué.

A partir du moment C, la tension V_{bat} est inférieure à la tension V_{OFF} et la batterie 3 est considérée comme défaillante.

Ainsi, on fournit un dispositif efficace, simple à réaliser, et particulièrement adapté pour l'état d'une batterie d'alimentation 3 d'un dispositif de surveillance.

## Revendications

1. Disjoncteur comportant un dispositif de surveillance (1) d'une alimentation électrique comportant:
- une série de premières bornes destinées à être connectées à une alimentation primaire (2) pour alimenter le dispositif de surveillance (1), l'alimentation électrique surveillée par le dispositif de surveillance (1) formant l'alimentation primaire (2),
- une batterie (3) connectée pour alimenter le dispositif de surveillance (1) comme alimentation secondaire, en cas de disparition de l'alimentation primaire (2),
- des moyens de mesure (6) configurés pour mesurer la tension (V_{bat}) à des bornes (3a) de la batterie (3),
- un circuit de gestion (5) configuré pour détecter une défaillance de la batterie (3),
**caractérisé en ce qu'**il comporte:
- un circuit de mémorisation (4) configuré pour enregistrer des indicateurs liés aux causes de déclenchement du disjoncteur et alimenté par la batterie (3) en cas de disparition de l'alimentation primaire (2),
- un comparateur (7) configuré pour comparer la tension mesurée par les moyens de mesure (6) avec des première et deuxième valeurs seuil (V_{OFF}, Vₘᵢₙ) représentant respectivement une batterie non récupérable et une batterie fonctionnelle, une sortie du comparateur (7) étant couplée au circuit de gestion (5),
- un interrupteur (10) configuré pour bloquer/autoriser le passage d'un courant de décharge (I_{d}) aux bornes de la batterie (3),
- un compteur (12) configuré pour compter une grandeur représentative du courant de décharge (I_{d}), une sortie du compteur (12) étant couplée au circuit de gestion (5),
**en ce que** les moyens de mesure (6) sont configurés pour mesurer la tension aux bornes de la batterie (3) lorsque le dispositif de surveillance (1) est alimenté par l'alimentation primaire (2) et que le circuit de gestion (5) est configuré pour détecter une défaillance de la batterie (3) lorsque le dispositif de surveillance (1) est alimenté par l'alimentation primaire (2) et pour commander l'état de l'interrupteur (10) en fonction de la comparaison de la tension mesurée (V_{bat}) avec les première et deuxième valeurs seuil (V_{OFF}, Vₘᵢₙ) et en fonction de la valeur du compteur (12) et **en ce que** le circuit de gestion (5) est configuré pour appliquer un courant de décharge (I_{d}) aux bornes de la batterie (3) si la tension mesurée (V_{bat}) est comprise entre les première et deuxième valeurs seuil (V_{OFF}, Vₘᵢₙ).

2. Procédé de gestion de la décharge d'une batterie (3) dans un disjoncteur muni d'un dispositif de surveillance (1) **caractérisé en ce qu'**il comporte les étapes suivantes :
- prévoir un dispositif de surveillance (1) d'une alimentation électrique muni :
∘ d'une première série de bornes destinées à être connectées à une alimentation électrique primaire, l'alimentation électrique primaire formant l'alimentation électrique à surveiller par le dispositif de surveillance (1),
∘ d'un circuit de mémorisation (4) configuré pour enregistrer des indicateurs liés aux grandeurs électriques mesurées de l'alimentation électrique et aux causes de déclenchement du disjoncteur,
∘ d'une batterie connectée pour alimenter au moins une partie du circuit de mémorisation (4) en cas de disparition de l'alimentation électrique primaire,
∘ des moyens de mesure (6) configurés pour mesurer la tension (V_{bat}) aux bornes de la batterie (3),
∘ un circuit de gestion (5) relié aux moyens de mesure (6) et configuré pour détecter une défaillance de la batterie (3) lorsque le dispositif de surveillance (1) est alimenté par l'alimentation électrique primaire,
∘ un compteur (12) configuré pour compter une grandeur représentative du courant de décharge (I_{d}), une sortie du compteur (12) étant couplée au circuit de gestion (5),
- détecter la présence de la batterie (3),
- mesurer (21) la tension aux bornes de la batterie (V_{bat}),
- comparer (22, 23) la tension (V_{bat}) mesurée aux bornes de la batterie (3) à des première et deuxième valeurs seuil (V_{OFF}, Vₘᵢₙ) représentant respectivement une batterie non récupérable et une batterie fonctionnelle,
- appliquer le courant de décharge (I_{d}) aux bornes de la batterie (3) si la tension mesurée (V_{bat}) est comprise entre les première et deuxième valeurs seuil (V_{OFF}, Vmin).

3. Procédé de gestion selon la revendication 2, **caractérisé en ce que** si la tension (V_{bat}) mesurée aux bornes de la batterie (3) est inférieure à la première valeur seuil (V_{OFF}), la batterie (3) est considérée comme défaillante par le circuit de gestion (5).

4. Procédé de gestion selon l'une des revendications 2 et 3, **caractérisé en ce qu'**il comporte les étapes suivantes :
- compter le nombre d'itérations d'application du courant de décharge (I_{d}),
- comparer ce nombre d'itérations à une valeur critique (N_{C}),
- considérer la batterie (3) comme défaillante si le nombre d'itérations est égal à la valeur critique (N_{C}).

5. Procédé de gestion selon l'une quelconque des revendications 2 à 4, **caractérisé en ce que** le courant de décharge (I_{d}) est un courant périodique avec alternance de périodes de décharge à un premier courant et de périodes de repos à un deuxième courant inférieur au premier courant ou à courant nul.

6. Procédé de gestion selon l'une des revendications 2 à 4, **caractérisé en ce que** le courant de décharge (I_{d}) est égal à 3mA.

## Patentansprüche

1. Schutzschalter, der mit einer Überwachungsvorrichtung (1) für eine elektrische Stromversorgung ausgestattet ist, umfassend:
- eine Reihe erster Klemmen zur Verbindung mit einer Primärstromversorgung (2), um die Überwachungsvorrichtung (1) mit Strom zu versorgen, wobei die Stromversorgung, die von der Überwachungsvorrichtung (1) überwacht wird, durch die Primärstromversorgung (2) gebildet wird,
- eine Batterie (3), die verbunden ist, um als Sekundärstromversorgung die Überwachungsvorrichtung (1) mit Strom zu versorgen, falls die Primärstromversorgung (2) ausfällt,
- Messmittel (6), die dazu konfiguriert sind, die Spannung (V_{bat}) an den Klemmen (3a) der Batterie (3) zu messen,
- eine Steuerungsschaltung (5), die dazu konfiguriert ist, einen Defekt der Batterie (3) zu detektieren,
**dadurch gekennzeichnet, dass** sie umfasst:
- eine Speicherschaltung (4), die dazu konfiguriert ist, Indikatoren zu speichern, die sich auf die Ursachen für die Auslösung des Schutzschalters beziehen, und die bei Ausfall der Primärstromversorgung (2) durch die Batterie (3) mit Strom versorgt wird,
- einen Komparator (7), der dazu konfiguriert ist, die von den Messmitteln (6) gemessene Spannung mit einem ersten und einem zweiten Schwellenwert (V_{OFF}, Vₘᵢₙ) zu vergleichen, die jeweils eine nicht wiederverwendbare Batterie und eine funktionsfähige Batterie darstellen, wobei ein Ausgang des Komparators (7) mit der Steuerungsschaltung (5) gekoppelt ist,
- einen Schalter (10), der dazu konfiguriert ist, den Durchfluss eines Entladestroms (I_{d}) an den Klemmen der Batterie (3) zu sperren/zuzulassen,
- einen Zähler (12), der dazu konfiguriert ist, eine Größe zu zählen, die repräsentativ für den Entladestrom (I_{d}) ist, wobei ein Ausgang des Zählers (12) mit der Steuerungsschaltung (5) gekoppelt ist,
dadurch, dass die Messmittel (6) dazu konfiguriert sind, die Spannung an den Klemmen der Batterie (3) zu messen, wenn die Überwachungsvorrichtung (1) durch die Primärstromversorgung (2) mit Strom versorgt wird, und die Steuerungsschaltung (5) dazu konfiguriert ist, einen Defekt der Batterie (3) zu detektieren, wenn die Überwachungsvorrichtung (1) durch die Primärstromversorgung (2) mit Strom versorgt wird, und den Zustand des Schalters (10) abhängig vom Vergleich der gemessenen Spannung (V_{bat}) mit dem ersten und dem zweiten Schwellenwert (V_{OFF}, Vₘᵢₙ) und abhängig vom Wert des Zählers (12) zu steuern, und dadurch, dass die Steuerungsschaltung (5) dazu konfiguriert ist, einen Entladestrom (I_{d}) an die Klemmen der Batterie (3) anzulegen, wenn die gemessene Spannung (V_{bat}) zwischen dem ersten und dem zweiten Schwellenwert (V_{OFF}, Vₘᵢₙ) liegt.

2. Entladungssteuerungsverfahren für eine Batterie (3) in einem Schutzschalter, der mit einer Überwachungsvorrichtung (1) ausgestattet ist, **dadurch gekennzeichnet, dass** es die folgenden Schritte umfasst:
- Bereitstellen einer Überwachungsvorrichtung (1) für eine elektrische Stromversorgung, die versehen ist mit:
∘ einer ersten Reihe von Klemmen zur Verbindung mit einer Primärstromversorgung, wobei die Stromversorgung, die von der Überwachungsvorrichtung (1) überwacht wird, durch die Primärstromversorgung gebildet wird,
∘ einer Speicherschaltung (4), die dazu konfiguriert ist, Indikatoren zu speichern, die sich auf die gemessenen elektrischen Größen der Stromversorgung und die Ursachen für die Auslösung des Schutzschalters beziehen,
∘ einer Batterie, die verbunden ist, um bei Ausfall der Primärstromversorgung mindestens einen Teil der Speicherschaltung (4) mit Strom zu versorgen,
∘ Messmitteln (6), die dazu konfiguriert sind, die Spannung (V_{bat}) an den Klemmen der Batterie (3) zu messen,
∘ einer Steuerungsschaltung (5), die mit den Messmitteln (6) verbunden ist und dazu konfiguriert ist, einen Defekt der Batterie (3) zu detektieren, wenn die Überwachungsvorrichtung (1) durch die Primärstromversorgung mit Strom versorgt wird,
∘ einem Zähler (12), der dazu konfiguriert ist, eine Größe zu zählen, die für den Entladestrom (I_{d}) repräsentativ ist, wobei ein Ausgang des Zählers (12) mit der Steuerungsschaltung (5) gekoppelt ist,
- Detektieren des Vorhandenseins der Batterie (3),
- Messen (21) der Spannung an den Batterieklemmen (V_{bat}),
- Vergleichen (22, 23) der an den Klemmen der Batterie (3) gemessenen Spannung (V_{bat}) mit einem ersten und einem zweiten Schwellenwert (V_{OFF}, Vₘᵢₙ), die jeweils eine nicht wiederverwendbare Batterie und eine funktionsfähige Batterie darstellen,
- Anlegen des Entladestroms (I_{d}) an die Klemmen der Batterie (3), wenn die gemessene Spannung (V_{bat}) zwischen dem ersten und dem zweiten Schwellenwert (V_{OFF}, Vₘᵢₙ) liegt.

3. Steuerungsverfahren nach Anspruch 2, **dadurch gekennzeichnet, dass** die Batterie (3) von der Steuerungsschaltung (5) als defekt betrachtet wird, wenn die an den Klemmen der Batterie (3) gemessene Spannung (V_{bat}) kleiner als der erste Schwellenwert (V_{OFF}) ist,

4. Steuerungsverfahren nach einem der Ansprüche 2 und 3, **dadurch gekennzeichnet, dass** es die folgenden Schritte umfasst:
- Zählen der Wiederholungszahl des Anlegens des Entladestroms (I_{d}),
- Vergleichen dieser Wiederholungszahl mit einem kritischen Wert (Nc),
- Betrachten der Batterie (3) als defekt, wenn die Wiederholungszahl dem kritischen Wert (Nc) entspricht.

5. Steuerungsverfahren nach einem der Ansprüche 2 bis 4, **dadurch gekennzeichnet, dass** der Entladestrom (I_{d}) ein periodischer Strom mit abwechselnden Entladeperioden bei einem ersten Strom und Ruheperioden bei einem zweiten Strom ist, der kleiner als der erste Strom oder ein Nullstrom ist.

6. Steuerungsverfahren nach einem der Ansprüche 2 bis 4, **dadurch gekennzeichnet, dass** der Entladestrom (I_{d}) gleich 3mA ist.

## Claims

1. A circuit breaker comprising a monitoring device (1) of an electric power supply comprising:
- a series of first terminals designed to be connected to a primary power supply (2) for supplying the monitoring device (1), the power supply monitored by the monitoring device (1) forming the primary power supply (2),
- a battery (3) connected to supply the monitoring device (1) as secondary power supply, in case of outage of the primary power supply (2),
- measuring means (6) configured to measure the voltage (V_{bat}) at terminals (3a) of the battery (3),
- a management circuit (5) to detect a malfunctioning of the battery (3),
**characterized in that** it comprises
- a storage circuit (4) configured to record indicators linked to the causes of tripping of the circuit breaker and supplied by the battery (3) in case of outage of the primary power supply (2),
- a comparator (7) configured to compare the voltage measured by the measuring means (6) with first and second threshold values (Vₘᵢₙ, V_{OFF}) representing respectively a non-recoverable battery and a functional battery, an output of the comparator (7) being coupled to the management circuit (5),
- a switch (10) configured to disable/enable flow of a discharge current (I_{d}) at the terminals of the battery (3),
- a counter (12) configured to count a quantity representative of the discharge current (I_{d}), an output of the counter (12) being coupled to the management circuit (5),
**in that** the measuring means (6) are configured to measure the voltage (V_{bat}) at terminals (3a) of the battery (3) when the monitoring device (1) is supplied by the primary power supply (2) and the management circuit (5) is configured to detect a failure of the battery (3) when the monitoring device (1) is supplied by the primary power supply (2) and to control the state of the switch (10) according to the comparison of the measured voltage (V_{bat}) with the first and second threshold values (Vₘᵢₙ, V_{OFF}) and according to the value of the counter (12) and **in that** the management circuit (5) is configured to apply a discharge current (I_{d}) to the terminals of the battery (3) if the measured voltage (V_{bat}) is comprised between the first and second threshold values (V_{OFF}, Vmin).

2. A management method of discharge of a battery (3) in a circuit breaker provided with a monitoring device (1) **characterized in that** it comprises the following steps:
- providing a monitoring device (1) of an electric power supply provided with:
∘ a first series of terminals designed to be connected to a primary electric power supply, the primary electric power supply forming the power supply to be monitored by the monitoring device (1),
∘ a storage circuit (4) configured to record indicators linked to the measured electric quantities of the electric power supply and the causes of the circuit breaker tripping,
∘ a battery connected to supply at least a part of the storage circuit (4) in case of outage of the primary electric power supply,
∘ measuring means (6) configured to measure the voltage (V_{bat}) at the terminals of the battery (3),
∘ a management circuit (5) connected to the measuring means (6) and configured to detect a malfunctioning of the battery (3) when the monitoring device (1) is powered by the primary electric power supply,
∘ a counter (12) configured to count un quantity representative of the discharge current (I_{d}), an output of the counter (12) being coupled to the management circuit (5),
- detecting the presence of the battery (3),
- measuring (21) the voltage at the terminals of the battery (V_{bat}),
- comparing (22, 23) the voltage (V_{bat}) measured at the terminals of the battery (3) with first and second threshold values (V_{OFF}, Vₘᵢₙ) representing respectively a non-recoverable battery and a functional battery,
- applying a discharge current (I_{d}) to the terminals of the battery (3) if the measured voltage (V_{bat}) is comprised between the first and second threshold values (V_{OFF}, Vₘᵢₙ).

3. The management method according to claim 2, **characterized in that** it if the voltage (V_{bat}) measured at the terminals of the battery (3) is lower than the first threshold value (V_{OFF}), the battery (3) is considered as being defective by the management circuit (5).

4. The management method according to one of claims 2 and 3, **characterized in that** it comprises the following steps:
- counting the number of iterations of application of the discharge current (I_{d}),
- comparing this number of iterations with a critical value (Nc),
- considering the battery (3) as being defective if the number of iterations is equal to the critical value (Nc).

5. The management method according to any one of claims 2 to 4, **characterized in that** the discharge current (I_{d}) is a periodic current with an alternation of discharge periods at a first current and of rest periods at a second current lower than the first current or at zero current.

6. The management method according to one of claims 2 to 4, **characterized in that** the discharge current (I_{d}) is equal to 3mA.
